Europäisches Patentamt

European Patent Office

Office européen des brevets

(19)

(11) Publication number: **0 230 480**
**A1**

(12) # EUROPEAN PATENT APPLICATION

(21) Application number: **85202132.8**

(22) Date of filing: **23.12.85**

(51) Int. Cl.³: **G 06 F 15/50**
**G 09 B 29/10**

(30) Priority: **06.12.85 NL 8503378**

(43) Date of publication of application:
**05.08.87 Bulletin 87/32**

(84) Designated Contracting States:
**AT BE CH DE FR GB IT LI LU NL SE**

(71) Applicant: **Poelstra, Theo Jogchum**
**Klokkengietershoeve 104**
**NL-7326 SC Apeldoorn(NL)**

(71) Applicant: **van Rijn, Dominicus Henricus Maria**
**Dommeloord 62**
**NL-5283 LN Boxtel(NL)**

(72) Inventor: **Poelstra, Theo Jogchum**
**Klokkengietershoeve 104**
**NL-7326 SC Apeldoorn(NL)**

(72) Inventor: **van Rijn, Dominicus Henricus Maria**
**Dommeloord 62**
**NL-5283 LN Boxtel(NL)**

(54) **Procedure for setting up and keeping up to date datafiles for road traffic.**

(57) Procedure for setting up and keeping up-to-date data files for road traffic.

The working procedure to be protected comprises the production (from driving recording-vehicles) of video tapes provided with site information using special optical and electronic devices, intended to support the computer operators in the process of setting up and keeping updated very large data files for traffic and transport.

EP 0 230 480 A1

Croydon Printing Company Ltd.

PATENT-APPLICATION.


**Procedure for setting up and keeping up-to-date datafiles for road traffic.**


Introduction.


In the world of traffic and transport an ever increasing number of electronic devices are being put into use; in particular there is a marked increase of computer applications, also on board of vehicles. It is obvious that board-computers should be perfected so that they can also be used for determining:
- routes and distances;
- generation of site information;
- the use of these data for the purpose of navigation;
- the processing of (coded) up-to-date route information via the radio receiver.
The procedure to be described here concentrates on the technique of the initial collection of the data necessary for navigation.


Problem.


To make navigation via the board-computer possible, two conditions are to be met in principle:
a) the availability of an electronic map, as it were the framework within or across which one moves, and
b) the updating of the location of the vehicle within the limits referred to in a).

The procedure to be described constitutes a means to solve the problem of the production and updating of data files for an electronic map as mentioned in a) in the most efficient way.

Solution.

The required data files which will be made for the purpose of navigation of the motorized road traffic now consist of two groups of data:
1) Metrical data: as it were the system of coordinates.
2) Non-metrical data which are added to the metrical data. There are a great many non-metrical data, for the greater part referring to matters of traffic technique and other traffic and object information.
On the whole very large files are concerned which can be made accessible to the user via CD-ROM only.
Solving the problem of compiling and updating these files in a very efficient way depends, on the one hand, on the application of a perfectly equipped production process and, on the other hand, on a ready support of that production process by supplying it with up-to-date information, both to enable the file (=map) to be as complete and up-to-date as possible, and to largely reduce expensive additional investigation in the field. The procedure to be described is aimed at these aspects.

The working procedure.

As indicated, the computer operators charged with the actual production of the total files, begin by setting up very specific metrical files, in which the network of roads becomes known in coordinates in a very special way. These metrical data (still without other information) are used to determine the location of the recording vehicles, using a specially on-board electronic device. These recording vehicles are equipped with modern video-cameras with specially made optical devices. While driving, exposures are made:

- in the direction of driving, in particular when approaching crossings, and

- perpendicular to the direction of driving, continuously, with a view to streetnames and house numbers. As for the exposures made when crossings are approached or of the crossings themselves, the site information (coordinates) has to be added to the tape.

With the aid of the video-tapes made, the computer operators can update and optimize their files.
Annex 1 shows a list of quickly available items; files generally do not contain these items in an organized form, however they are essential to a navigation system. The relations are made through coordinates. Playback monitors will be made available to the operators: specific street parts can be projected by keying the initial and the final coordinates of the relevant street parts. The tapes used in this way can also be applied for recording the information or parts of it onto other media, such as video long-play (video records), CD-ROM etc. for other specific purposes.

Annex 1.


The following kind of information is made
available through the system to be protected:
- traffic signs
- pedestrian crossings
- traffic lights
- bus- and tramstops
- type of pavement
- tram-rails
- filter indications (traffic)
- level crossings (train)
- signposts
- hectometre signs
- tunnels (names)
- road markings
- viaducts (names)
- height limitations
- bridges
- house numbers
- ferry-boats
- toll-locations
- frontier crossings
- level crossings (4-lane N-roads)
- parking bays
- route-indication for dangerous material
- other street equipment
- geographic locations (glocs)
- commercial locations (clocs)
- special locations (slocs)

Claims


1. A working procedure for setting up and keeping up-to-date very large data files for navigation purposes for motorized road traffic, intended to support computer operators, comprising the use of driving recording-vehicles, producing specially made video tapes provided with site information, characterised by the fact that these video tapes are being produced using specially made optical devices and specific site information, i.e. X, Y-coordinates, thus improving the computerised production process of the large data files needed, in the sense of completeness and actuality, and avoiding the very expensive additional investigations in the field afterwards.


2. The specially made optical devices mentioned in claim 1, enabling the computer operators to examine at least 180 degrees in the field of view, thus being able to read street names, house numbers, etc.


3. The specially made electronic devices which enables the driver of the recording-vehicle to add to the video tape the site-coordinates.

European Patent Office

## DOCUMENTS CONSIDERED TO BE RELEVANT

| Category | Citation of document with indication, where appropriate, of relevant passages | Relevant to claim | CLASSIFICATION OF THE APPLICATION (Int. Cl 4) |
|---|---|---|---|
| Y | US-A-4 396 942 (J. GATES)<br>* figures 1, 2; column 4, lines 17-40; column 5, lines 45-55; column 6, lines 13-18 * | 1 | G 06 F 15/50<br>G 09 B 29/10 |
| A | | 2,3 | |
| | --- | | |
| Y | DE-A-3 235 993 (B. BREIT)<br>* figure 1 * | 1 | |
| | ----- | | |

TECHNICAL FIELDS SEARCHED (Int. Cl.4)

G 01 C 11/00
G 01 C 15/00
G 01 C 21/00
G 06 F 15/50
G 09 B 29/10

The present search report has been drawn up for all claims

| Place of search | Date of completion of the search | Examiner |
|---|---|---|
| BERLIN | 10-04-1987 | ARENDT M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                      

& : member of the same patent family, corresponding document

EPO Form 1503 03 82